Europäisches Patentamt

European Patent Office

Office européen des brevets

(19)

(11) Publication number : **0 416 651 B1**

(12)

# EUROPEAN PATENT SPECIFICATION

(45) Date of publication of patent specification :
09.11.94 Bulletin 94/45

(51) Int. Cl.⁵ : **G02B 13/00,** G02B 13/24, G02B 27/00

(21) Application number : 90117300.5

(22) Date of filing : 07.09.90

(54) Apochromatic lens system.

(30) Priority : 08.09.89 JP 234474/89

(43) Date of publication of application :
13.03.91 Bulletin 91/11

(45) Publication of the grant of the patent :
09.11.94 Bulletin 94/45

(84) Designated Contracting States :
DE FR GB

(56) References cited :
EP-A- 0 276 865
DE-A- 2 001 668
DE-A- 2 554 952
FR-A- 2 370 293
GB-A- 1 196 427
US-A- 3 035 488
US-A- 4 013 348
US-A- 4 249 204

(73) Proprietor : **Dainippon Screen Mfg. Co., Ltd.**
**1-1, Tenjinkitamachi**
**Teranouchi-Agaru 4-chome**
**Horikawa-Dori**
**Kamikyo-ku Kyoto 602 (JP)**

(72) Inventor : **Kataoka, Yoshikazu, Dainip. Screen**
**Co., Ltd., 1-1**
**Tenjinkitamachi,**
**Teranouchi-agaru 4-chome**
**Horikawa-dori, Kamikyo-ku, Kyoto (JP)**

(74) Representative : **Goddar, Heinz J., Dr. et al**
**FORRESTER & BOEHMERT**
**Franz-Joseph-Strasse 38**
**D-80801 München (DE)**

## Description

BACKGROUND OF THE INVENTION

Field of the Invention

The present invention relates to an apochromatic lens system, which can be corrected for chromatic aberration at a plurality of wavelengths. In particular, the present invention relates to an apochromatic lens system which can be used as a projection lens system. The system is especially suitable for projection exposure to form a photomask pattern on a substrate of a semiconductor device such as an integrated circuit.

Description of the Prior Art

Exposing through a photomask having a mask pattern is one of process for fabricating a semiconductor device. In the exposing step, a photoresist coating a semiconductor substrate is exposed to light transilluminated through a photomask having a predetermined mask pattern. Generally, a plurality of photomasks, each having an individual mask pattern, are necessary to fabricate a single semiconductor device. Further, the exposing step must be performed for each photomask; that is, the photomask must be aligned so that the pattern of the photomask is matched with a pattern previously formed on the semiconductor substrate with a predetermined relationship. In the prior art, a microscope is used to align the photomask by observing.

As a rule, a photoresist material is highly sensitive to light with a short wavelength but not sensitive to light with a long wavelength. Therefore, light with a long wavelength as a wavelength of 546.07 nm (e line) is used to align the photomask, whereas light with a short wavelength as a wavelength of 435.83 nm (g line) is used to expose the photoresist.

Thus, in general, when mask patterns of photomasks are formed on a semiconductor substrate, the photomasks are aligned with a long wavelength light. Thereafter, the exposing step is performed with a short wavelength light. Hence, it is desirable to use a lens system which is corrected for chromatic aberration at the light with long wavelength as well as at the light with short wavelength. If a lens system has chromatic aberration at the light with long wavelength and at the light with short wavelength, an image formation point of the mask pattern in aligning differs from that in exposing along an optical axis. In such a case, either the photomask or the semiconductor substrate must be moved along the optical axis in every aligning and exposing in order to be in focus. Moreover, the photomask or the substrate often slips while being moved along the optical axis. As a consequent, all the work devoted to the aligning ends in vain.

On the other hand, in order to reduce exposure time and improve efficiency of exposing, it is desirable to use light with a plurality of wavelengths. For example, exposing of a photoresist using light with a wavelength of 435.83 nm (the g line) and light with a wavelength of 404.66 nm (h line) is more favorable than exposing using only the g line. However, when light radiations of two different short wavelengths, e.g., the g line and the h line, are used in exposing, a lens system must be corrected for chromatic aberration at least the g line and the h line.

As is obvious from the above, it is advantageous if a photomask and a substrate do not have to be moved along the optical axis in every aligning and exposing while reducing exposure time. In order to achieve this, a lens system must be corrected for chromatic aberration at a long wavelength used in aligning and two different short wavelengths used in exposing. However, it is extremely difficult to obtain such a lens system.

FR-A- 2,370,293 discloses an optical lens system for correcting chromatic aberrations which uses a first filter and at least one colour filter of a different thickness to correct for chromatic aberration.

SUMMARY OF THE INVENTION

The present invention relates to an apochromatic lens system, comprising: a lens system; a plane glass for cooperating with the lens system to be corrected for chromatic aberration at first and second wavelengths when the plane glass is disposed on the optical axis of the lens system; and a plane lens formed by a planoconvex lens and a plano-concave lens, the concave surface of the plano-concave lens facing the convex surface of the plano-convex lens whereby the plane lens is identical to the plane glass in thickness, the plane lens being interchangeable with the plane glass, the plane lens cooperating with the lens system to be corrected for chromatic aberration at the first wavelength and a third wavelength when the plane lens is disposed on the optical axis of the lens system.

A principal object of the present invention is to provide an apochromatic lens system which is corrected for chromatic aberration at three different short wavelengths.

These and other objects, features, aspects and advantages of the present invention will become more apparent from the following detailed description of the present invention when taken in conjunction with the accompanying drawings.

BRIEF DESCRIPTION OF THE DRAWINGS

Figs 1A and 1B are explanatory diagrams explaining the principle of the present invention;

Figs. 2A and 2B show spherical aberrations of lens systems of Figs. 1A and 1B, respectively;

Figs. 3A and 3B are schematic diagrams of an apochromatic lens system according to the first embodiment of the present invention;

Figs. 4A and 4B show spherical aberrations of the lens systems shown in Figs. 3A and 3B for aligning and for exposing, respectively;

Figs. 5A and 5B show astigmatisms of the lens systems shown in Figs. 3A and 3B for aligning and for exposing, respectively;

Figs. 6A and 6B show distortion of the lens systems shown in Figs. 3A and 3B for aligning and for exposing, respectively;

Figs. 7A and 7B are schematic diagrams of an apochromatic lens system according to the second embodiment of the present invention;

Figs. 8A and 8B show spherical aberrations of the lens systems shown in Figs. 7A and 7B for aligning and for exposing, respectively;

Figs. 9A and 9B show astigmatisms of the lens systems shown in Figs. 7A and 7B for aligning and for exposing, respectively;

Figs. 10A and 10B show distortion aberrations of the lens systems shown in Figs. 7A and 7B for aligning and for exposing, respectively;

Figs. 11A and 11B are schematic diagrams of a lens system illustrated to be compared with the embodiments of the present invention;

Figs. 12A and 12B are schematic diagrams of an apochromatic lens system according to the third embodiment of the present invention;

Figs. 13A and 13B show spherical aberrations of the lens systems shown in Figs. 12A and 12B for aligning and for exposing, respectively;

Figs. 14A and 14B show astigmatisms of the lens systems shown in Figs. 12A and 12B for aligning and for exposing, respectively;

Figs. 15A and 15B show distortion aberrations of the lens systems shown in Figs. 12A and 12B for aligning and for exposing, respectively;

Figs. 16A and 16B are schematic diagrams of an apochromatic lens system according to the fourth embodiment of the present invention;

Figs. 17A and 17B show spherical aberrations of the lens systems shown in Figs. 16A and 16B for aligning and for exposing, respectively;

Figs. 18A and 18B show astigmatisms of the lens systems shown in Figs. 16A and 16B for aligning and for exposing, respectively;

Figs. 19A and 19B show distortion aberrations of the lens systems shown in Figs. 16A and 16B for aligning and for exposing, respectively;

Figs. 20A and 20B are schematic diagrams of an exposing apparatus employing the apochromatic lens system according to the first embodiment of the present invention;

Fig. 21 is a perspective view of a photomask;

Fig. 22 is a perspective view of a semiconductor device;

Fig. 23 illustrates a holder holding a plane lens and a plane glass;

Fig. 24 is block diagram of electrical structures of the exposing apparatus;

Fig. 25 is a flow chart of operations of the exposing apparatus; and

Fig. 26 illustrates a portion of an overlapped images of a mark on the photomask with an alignment mark on the semiconductor device.

DESCRIPTION OF THE PREFERRED EMBODIMENTS

A. Principle of the Invention

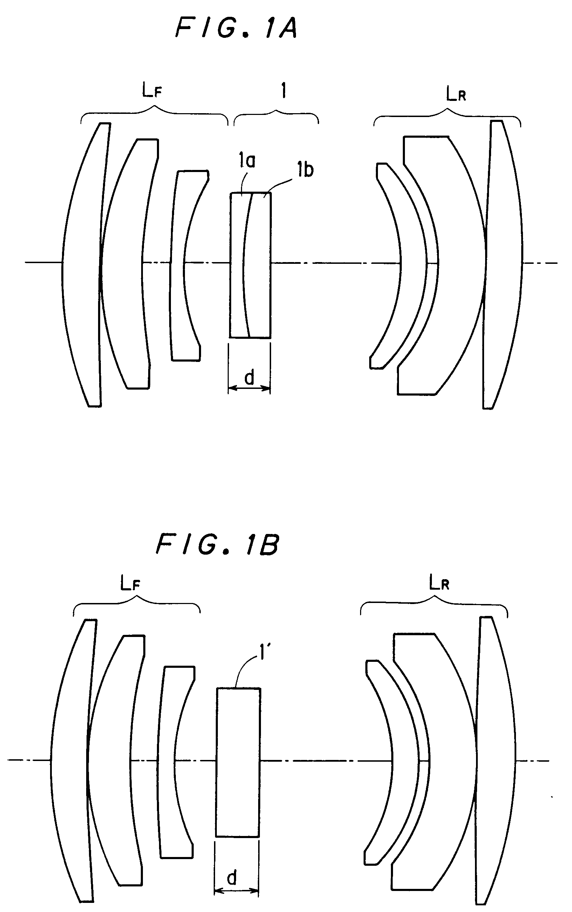

Figs. 1A and 1B are explanatory diagrams showing the principle of the present invention. Fig. 1A shows an arrangement of lenses for aligning and Fig. 1B shows an arrangement of lenses for exposing. The lens system of Fig. 1A for aligning comprises a front lens group $L_F$ disposed in an object side (left-hand side of the figure) and a rear lens group $L_R$ disposed in an image formation side (right-hand side of figure). These lens groups $L_F$ and $L_R$ are identical in structure to the lens groups for the exposing shown in Fig. 1B. While on the contrary, optical elements 1 and 1' of Figs. 1A and 1B with the prescribed thickness of $\underline{d}$, placed between the front lens group $L_F$ and the rear lens group $L_R$, have different structures. In other words, the optical elements 1 and 1' are interchangeable depending on whether they are used in the aligning or in the exposing.

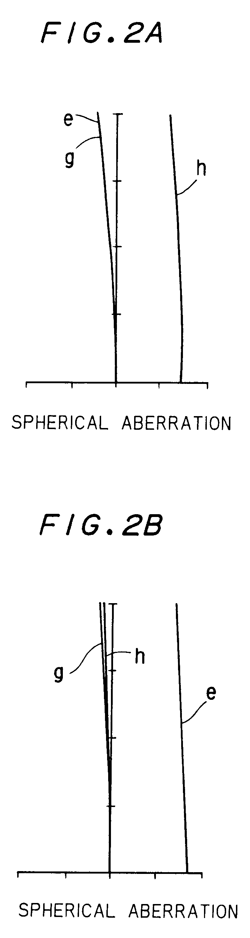

As shown in Fig. 1B, the optical element 1' for exposing is made of plane glass with the thickness of $\underline{d}$. The lens system shown in Fig. 1B is corrected for chromatic aberration at a first-wavelength light and a second-wavelength light such as the $\underline{g}$ line and the $\underline{h}$ line (Fig. 2B). The correction for such chromatic aberration is easily performed by selecting a proper combination of lenses and optical element 1' for the lens system.

On the other hand, as shown in Fig. 1A, the optical element 1 used in aligning is made of plane glass. The plane glass 1 comprises a plano-concave 1a and a plano-convex lens 1b, which are made of two different kinds of glass materials, respectively. The curved surfaces of the two lenses are joined to each other, to thereby form the optical element (plane glass) 1. The glass material forming the plano-concave lens 1a and that of the plano-convex lens 1b have approximately the same index of refraction at the first-wavelength as that of the plane glass 1'. However, the dispersion values of the two glass materials are different from each other. The lens system shown in Fig. 1a has no chromatic aberration at the first-wavelength and a third-wavelength, such as a wavelength of 435.83 nm (the $\underline{g}$ line) and a wavelength of 546.07 nm (the $\underline{e}$ line) as shown in Fig. 2A.

It is to be noted that the plano-concave and plano-convex lenses 1a and 1b have the same index of refraction at the first-wavelength (the $\underline{g}$ line) as that of the plane glass 1'. This in turn means that the lens systems of Figs. 1A and 1B are optically equivalent. Hence, the first-wavelength light (the $\underline{g}$ line) in the lens system for aligning shown in Fig. 1A is imaged at the same point as in the lens system for exposing shown in Fig. 1B. Further, the lens system for aligning has no chromatic aberration at the first-wavelength and the third-wavelength (the $\underline{g}$ line and the $\underline{e}$ line) as illustrated in Fig. 2A, while the lens system for exposing has no chromatic aberration at the first-wavelength and the second-wavelength (the $\underline{g}$ line and the $\underline{h}$ line). Therefore, the image point of the third-wavelength light (the $\underline{e}$ line) in aligning is approximate not only to the image point of the first-wavelength light (the $\underline{g}$ line) but also to the image point of the second-wavelength light (the $\underline{h}$ line) in exposing.

In addition, in such a lens system structured as above, an image size can be altered without altering the image point by moving the optical element 1 or 1' along the optical axis. This is because the position, where the incident light strikes the optical element 1 or 1', varies as moving the optical element 1 or 1' along the optical axis. Accordingly, the image size of the third-wavelength light (the $\underline{e}$ line) in aligning coincides with that of the first and second-wavelength lights (the $\underline{g}$ line and the $\underline{h}$ line) in exposing, if the optical element 1 or 1' is properly located on the optical axis.

Hence, in the lens system designed as above, the image of the $\underline{e}$ line through aligning can be approximate to the images of the $\underline{g}$ line and the $\underline{h}$ line through exposing, by replacing the optical element 1 or 1' in aligning and in exposing. As a consequent, a photomask and a substrate do not have to be moved along an optical axis every aligning or exposing. This enables the efficient work, and further, prevents the misalignment between the mask pattern and the pattern formed onto the substrate.

B. First Embodiment

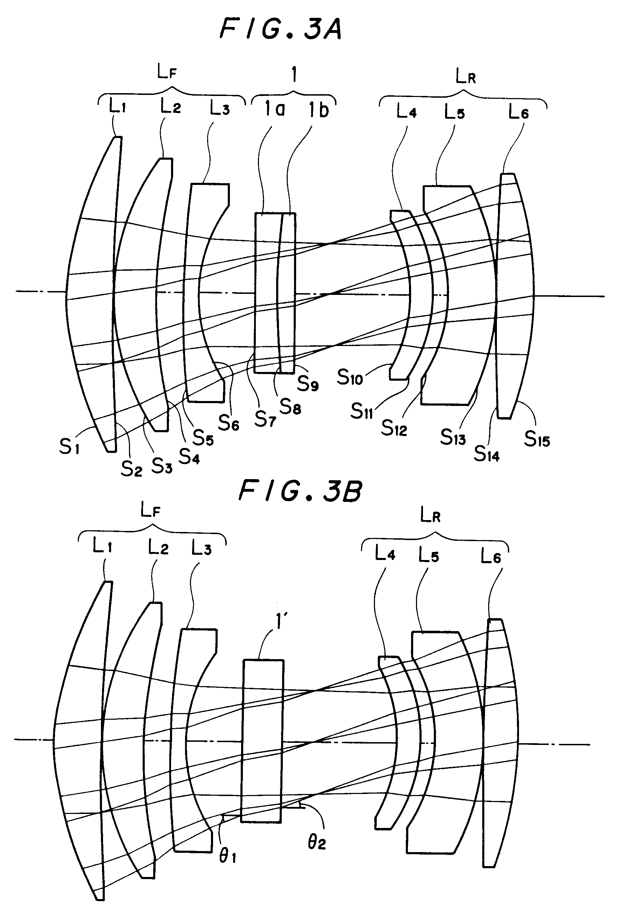

Figs. 3A and 3B are diagrams of an apochromatic lens system according to the first embodiment of the present invention. Fig. 3A shows a structure of the lens system for aligning and Fig. 3B shows a structure of the lens system for exposing. As shown in Fig. 3A, the lens system for aligning comprises a front lens group $L_F$, a plane lens 1 and a rear lens group $L_R$ which are serially arranged from an object side (left-hand side of the figure). The front lens group $L_F$ includes first to third lenses $L_1$ to $L_3$ serially arranged from the object side and spaced apart from each other. The values of the spacing between the three lenses $L_1$ to $L_3$ will be described later. The plane lens 1 includes plano-concave and plano-convex lenses 1a and 1b. Each of lenses 1a and 1b has a curved surface. The curved surface of lens 1a is equal to that of lens 1b in a radius of curvature. The curved surfaces of the plano-concave and plano-convex lenses 1a and 1b are joined to each other, to thereby form the plane lens 1 with parallel planes. The rear lens group $L_R$ includes fourth to sixth lenses $L_4$ to $L_6$ serially arranged from the object side and spaced from each other. The values of spacing between the three lenses will be described later. Table 1A shows lens data of the lens system for aligning structured as above.

Table 1A

| i | radius of curvature $r_i$ | value of thickness or spacing $d_i$ | refractive index at d light | dispersion value $\nu_d$ |
|---|---|---|---|---|
| 1 | 43.41538 | 6.480122 | $n_1 = 1.69350$ | $\nu_1 = 53.3$ |
| 2 | 308.90689 | 0.100000 | | |
| 3 | 34.60635 | 5.714502 | $n_2 = 1.70030$ | $\nu_2 = 47.8$ |
| 4 | 72.67101 | 3.685353 | | |
| 5 | 143.71997 | 2.194718 | $n_3 = 1.68893$ | $\nu_3 = 31.2$ |
| 6 | 23.23475 | 7.610805 | | |
| 7 | $\infty$ | 3.489249 | $n_{1a} = 1.69895$ | $\nu_{1a} = 30.1$ |
| 8 | 142.20425 | 2.326166 | $n_{1b} = 1.71300$ | $\nu_{1b} = 53.9$ |
| 9 | $\infty$ | 15.867274 | | |
| 10 | −21.81461 | 3.333307 | $n_4 = 1.69350$ | $\nu_4 = 53.3$ |
| 11 | −20.62952 | 2.099601 | | |
| 12 | −21.07478 | 6.774572 | $n_5 = 1.68893$ | $\nu_5 = 31.2$ |
| 13 | −31.14837 | 0.183597 | | |
| 14 | 1984.65000 | 4.725967 | $n_6 = 1.61272$ | $\nu_6 = 58.6$ |
| 15 | −58.36856 | | | |

In the table, $r_i$ (i= 1, 2, ... 15) is the radius of curvature of a lens surface $S_i$. For example, $r_1$ represents the radius of curvature of the convex surface $S_1$ of the first lens $L_1$, and $r_2$ represents the radius of curvature of the surface $S_2$ of the first lens $L_1$ which surface faces the image formation side. The symbol $r_8$ represents the radius of curvature of the joining surface of a plano-concave and plano-convex lenses 1a and 1b. Symbols $d_1$, $d_3$, $d_5$, $d_7$, $d_8$, $d_{10}$, $d_{12}$ and $d_{14}$ represent the thickness values of the first, the second, the third, the plano-concave, the plano-convex, the fourth, the fifth and sixth lenses $L_1$, $L_2$, $L_3$, 1a, 1b, $L_4$, $L_5$ and $L_6$, respectively. Symbols $d_2$ and $d_4$ represent the spacing values between the adjacent lenses of the three lenses $L_1$ to $L_3$, respectively. Symbol $d_6$ represents the spacing value between the third lens $L_3$ and the plane lens 1, while $d_9$ is the specing value between the fourth lens $L_4$ and the plane lens 1. Symbols $d_{11}$ and $d_{13}$ represent the spacing values between the adjacent lenses of the three lenses $L_4$ to $L_6$, respectively. Symbols $n_1$ to $n_6$ are the indices of refraction of the first to sixth lenses $L_1$ to $L_6$ with respect to d light (587.56 nm), respectively. Symbol $n_{1a}$ is the refractive index of the plano-concave lens 1a while $n_{1b}$ is the index of the plano-convex lens 1b. Symbols $\nu_1$ to $\nu_6$ denote the dispersion values of the first to sixth lenses $L_1$ to $L_6$, respectively. Symbols $\nu_{1a}$ and $\nu_{1b}$ denote the dispersion values of the plano-concave and plano-convex lenses 1a and 1b, respectively. The indices of refraction $n_{ga}$ and $n_{gb}$ of the plano-concave and the plano-convex lenses 1a and 1b with respect to g line (435.83 nm) are as follows. These values are not given in Table 1A.

$n_{ga} = 1.72941$, $n_{gb} = 1.72939$

The focal length $\underline{f}$, the total field angle $2\theta$, the F-number F and the magnification M of this apochromatic lens system whose lens data are shown in Table 1A are:

    f = 100.00,     $2\theta$ = 22.2°

    F = 4,     M = 0.5

    On the other hand, the lens system for exposing shown in Fig. 3B is exactly the same in structure as the lens system for aligning except that the plane glass 1′ is used instead of the plane glass 1. The lens data of the lens system for exposing are shown in Table 1B.

Table 1B

| i | radius of curvature $r_i$ | value of thickness or spacing $d_i$ | refractive index at d light | dispersion value $\nu_d$ |
|---|---|---|---|---|
| 1 | 43.41538 | 6.480122 | $n_1$ =1.69350 | $\nu_1$ =53.3 |
| 2 | 308.90689 | 0.100000 | | |
| 3 | 34.60635 | 5.714502 | $n_2$ =1.70030 | $\nu_2$ =47.8 |
| 4 | 72.67101 | 3.685353 | | |
| 5 | 143.71997 | 2.194718 | $n_3$ =1.68893 | $\nu_3$ =31.2 |
| 6 | 23.23475 | 7.610805 | | |
| 7 | $\infty$ | 5.815415 | | |
| 8 | . . . | . . . | n =1.71300 | $\nu$ =53.9 |
| 9 | $\infty$ | 15.867274 | | |
| 10 | −21.81461 | 3.333307 | $n_4$ =1.69350 | $\nu_4$ =53.3 |
| 11 | −20.62952 | 2.099601 | | |
| 12 | −21.07478 | 6.774572 | $n_5$ =1.68893 | $\nu_5$ =31.2 |
| 13 | −31.14837 | 0.183597 | | |
| 14 | 1984.65000 | 4.725967 | $n_6$ =1.61272 | $\nu_6$ =58.6 |
| 15 | −58.36856 | | | |

In the table, symbols $d_7$, n and $\nu$ in denote the thickness, the refractive index with respect to the the d light and the dispersion value of the plane glass 1′, respectively. Other symbols are the same as those in Table 1A. The refractive index $n_g$ of the plane glass 1′ with respect to the g line is shown for reference:

    $n_g$ = 1.72939

    The focal length f, the total field angle $2\theta$, the F-number F and the magnification M of the apochromatic lens system whose lens data are shown in Table 1B are set as follows:

    f = 100.00,     $2\theta$ = 22.2°

    F = 4,     M = 0.5

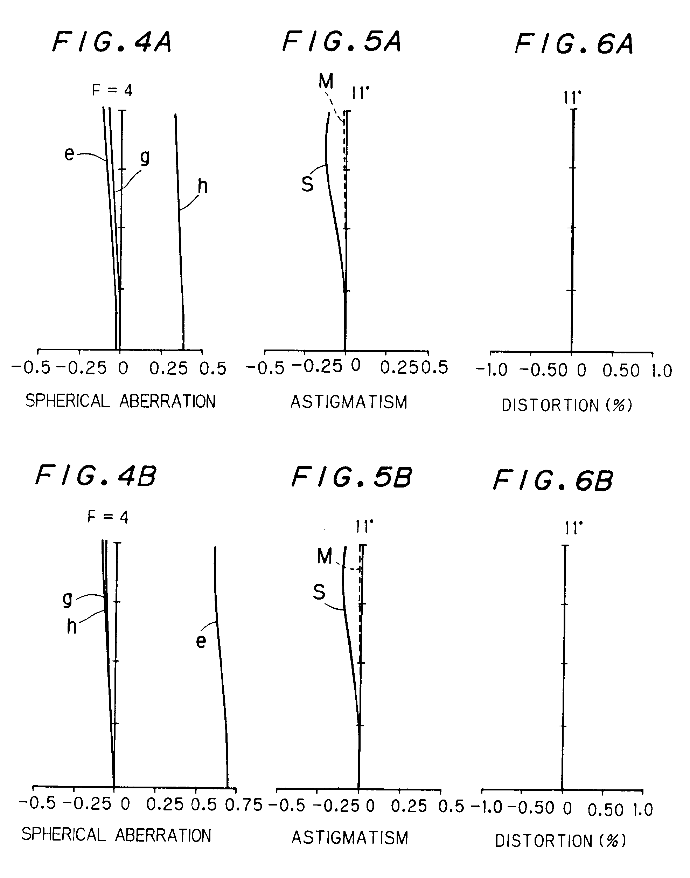

    Figs. 4A and 4B show the spherical aberrations of the lens systems in aligning and in exposing, respectively. Figs. 5A and 5B show the astigmatisms of the lens systems in aligning and in exposing, respectively. Figs. 6A and 6B show the distortion of the lens systems in aligning and in exposing, respectively. In the Figs.

4A and 4B, symbols $\underline{e}$, $\underline{g}$ and $\underline{h}$ denote the spherical aberrations with respect to the $\underline{e}$ line (546.07 nm), the $\underline{g}$ line (435.83 nm) and the $\underline{h}$ line (404.66 nm), respectively. In Figs. 5A and 5B, symbol S (solid lines) represents a sagittal image surface with respect to the $\underline{g}$ line, and symbol M (dotted lines) represents a meridional image surface with respect to the g line. The symbols for various values set forth above will be used to explain the following embodiments.

In the first embodiment of the present invention, the plane glass 1' and the plano-convex lens 1b are made of the same glass material (hereinafter referred to as "glass material A") while the plano-concave lens 1a is made of glass material (hereinafter referred to as "glass material B") which is approximate to the glass material A in refractive index but different from the same in dispersion value. The above can easily be seen in Tables 1A and 1B. However, this combination of these glass materials is not limiting. For instance, the plane glass 1' and the plano-concave lens 1a can be made of the glass material A while the plano-convex lens 1b can be made of the glass material B. Other examples of the combination of the glass materials A and B are shown in Table 2.

Table 2

| glass material | $n_g$ | $n_e$ | $\nu_e$ |
|---|---|---|---|
| BK7 | 1.52621 | 1.51825 | 63.9 |
| KF3 | 1.52628 | 1.51678 | 54.4 |
| SK1 | 1.62370 | 1.61283 | 56.2 |
| F5 | 1.62382 | 1.60718 | 37.7 |
| SK11 | 1.57531 | 1.56605 | 60.5 |
| LLF3 | 1.57522 | 1.56296 | 46.7 |
| LaK11 | 1.67255 | 1.66103 | 57.1 |
| SF2 | 1.67253 | 1.65223 | 33.6 |
| LaK12 | 1.69312 | 1.68082 | 55.1 |
| SF19 | 1.69298 | 1.67158 | 32.8 |
| LaK8 | 1.72944 | 1.71615 | 53.6 |
| SF15 | 1.72933 | 1.70443 | 29.9 |
| laF010 | 1.76205 | 1.74679 | 49.1 |
| SF10 | 1.76191 | 1.73429 | 28.2 |

## C. Second Embodiment

Although the $\underline{g}$ line (435.83 nm) is employed as the first-wavelength light to achieve the apochromatic lens system in the first embodiment, the $\underline{h}$ line (404.66 nm) can be employed instead as will be hereinafter described.

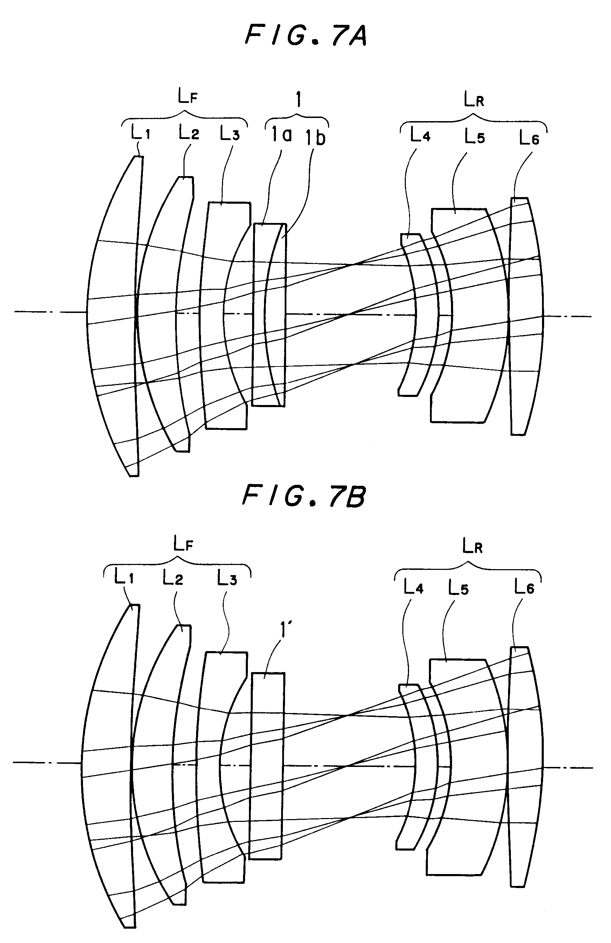

Figs. 7A and 7B are schematic diagrams of an apochromatic lens system according to the second embodiment of the present invention. Fig. 7A shows an arrangement of a lens system for aligning and Fig. 7B shows an arrangement of a lens system for exposing. The structures of the lens systems for aligning and for exposing are identical to those of the first embodiment. Therefore, the descriptions thereof are omitted here. Table 3A shows the lens data of the lens system for aligning.

Table 3A

| i | radius of curvature $r_i$ | value of thickness or spacing $d_i$ | refractive index at d light | dispersion value $\nu_d$ |
|---|---|---|---|---|
| 1 | 44.04882 | 6.629734 | $n_1 = 1.69350$ | $\nu_1 = 53.3$ |
| 2 | 346.75669 | 0.100000 | | |
| 3 | 35.06825 | 5.776424 | $n_2 = 1.70030$ | $\nu_2 = 47.8$ |
| 4 | 74.14126 | 3.245853 | | |
| 5 | 149.61818 | 3.244472 | $n_3 = 1.68893$ | $\nu_3 = 31.2$ |
| 6 | 23.37074 | 3.822617 | | |
| 7 | $\infty$ | 2.000000 | $n_{1a} = 1.60729$ | $\nu_{1a} = 49.2$ |
| 8 | 34.40785 | 3.000000 | $n_{1b} = 1.61025$ | $\nu_{1b} = 56.5$ |
| 9 | $\infty$ | 18.486614 | | |
| 10 | -23.73420 | 3.291906 | $n_4 = 1.69350$ | $\nu_4 = 53.3$ |
| 11 | -22.17396 | 1.938192 | | |
| 12 | -22.29975 | 7.911825 | $n_5 = 1.68893$ | $\nu_5 = 31.2$ |
| 13 | -33.86792 | 0.100000 | | |
| 14 | 991.26953 | 4.624920 | $n_6 = 1.61272$ | $\nu_6 = 58.6$ |
| 15 | -61.12865 | | | |

The refractive indices of plano-concave and plano-convex lenses 1a and 1b with respect to the h line (404.66 nm) are shown below for reference. These values are not provided in Table 3A.

$n_{ha} = 1.62872$, $n_{hb} = 1.62863$

The focal length $\underline{f}$, the total field angle $2\theta$, the F number F and the magnification M of the apochromatic lens system whose lens data are shown in Table 3A are set as follows:

f = 100.00, $2\theta = 22.2°$

F = 4, M = 0.5

The lens system for exposing, on the other hand, has the data shown in Table 3B.

Table 3B

| i | radius of curvature $r_i$ | value of thickness or spacing $d_i$ | refractive index at d light | dispersion value $\nu_d$ |
|---|---|---|---|---|
| 1 | 44.04882 | 6.629734 | $n_1 = 1.69350$ | $\nu_1 = 53.3$ |
| 2 | 346.75669 | 0.100000 | | |
| 3 | 35.06825 | 5.776424 | $n_2 = 1.70030$ | $\nu_2 = 47.8$ |
| 4 | 74.14126 | 3.245853 | | |
| 5 | 149.61818 | 3.244472 | $n_3 = 1.68893$ | $\nu_3 = 31.2$ |
| 6 | 23.37074 | 3.822617 | | |
| 7 | $\infty$ | 5.000000 | | |
| 8 | . . . | | $n = 1.61025$ | $\nu = 56.5$ |
| 9 | $\infty$ | 18.486614 | | |
| 10 | -23.73420 | 3.291906 | $n_4 = 1.69350$ | $\nu_4 = 53.3$ |
| 11 | -22.17396 | 1.938192 | | |
| 12 | -22.29975 | 7.911825 | $n_5 = 1.68893$ | $\nu_5 = 31.2$ |
| 13 | -33.86792 | 0.100000 | | |
| 14 | 991.26953 | 4.624920 | $n_6 = 1.61272$ | $\nu_6 = 58.6$ |
| 15 | -61.12865 | | | |

The refractive index of the plane glass 1' with respect to the h line (404.66 nm) is given below for reference. The value is not provided in Table 3B.

$n_h = 1.62863$

The focal length f, the total field angle 2θ, the F number F and the magnification M of the apochromatic lens system whose lens data are shown in Table 3B are set as follows:

f = 100.00,     2θ = 22.2°
F = 4,     M = 0.5

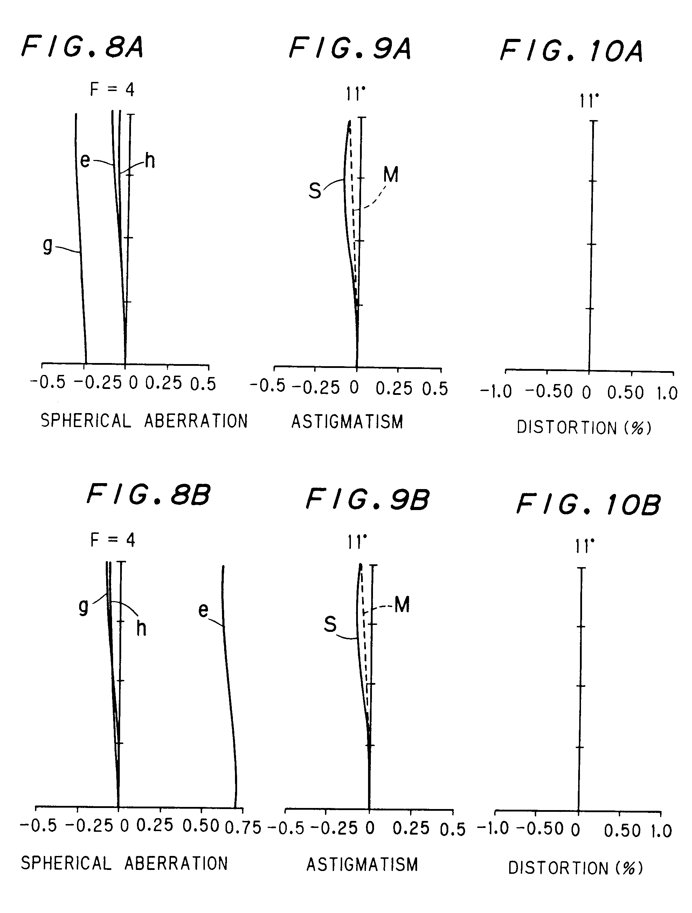

Figs. 8A and 8B show the spherical aberrations of the lens systems in aligning and in exposing, respectively. Figs. 9A and 9B show the astigmatisms of the lens systems in aligning and in exposing, respectively. Figs. 10A and 10B show the distortion aberrations of the lens systems in aligning and in exposing, respectively.

In Figs. 9A and 9B, symbol S represents a sagittal image surface, and symbol M represents a meridional image surfaces.

Also in the second embodiment, the plane glass 1' and the plano-convex lens 1b are made of the same glass material while the plano-concave lens 1a is made of the glass material which is approximate to the mentioned glass material in refractive index but different from the same in dispersion value, as in the first embodiment. However, this combination of the glass materials is not limiting. Other examples of the combination are shown in Table 4.

Table 4

| glass material | $n_h$ | $n_e$ | $\nu_e$ |
|---|---|---|---|
| SK1 | 1.62863 | 1.61283 | 56.2 |
| BaF5 | 1.62872 | 1.61023 | 48.9 |
| SK16 | 1.63778 | 1.62287 | 60.0 |
| KzFS4 | 1.63776 | 1.61673 | 43.6 |

### D. Effect of the First and Second Embodiments

As can be understood from the first and second embodiments, the image produces by the lens system for aligning when it was used with the third-wavelength light (the e line), coincides with the image produces by the lens system for exposing when it was used with the first and second-wavelength light (the g line and the h line). Aligning of the photomask is performed using the e line after placing the plane lens 1 at the prescribed position as shown in Fig. 3A (or 7A). Next, the plane glass 1 is replaced by the plane glass 1' as shown in Fig. 3B (or 7B). Then, exposing is performed without adjusting the location of the photomask or the substrate. Thus, this improves exposure efficiency, and at the same time, prevents the frequent slippage of a photomask or a substrate which has been a problem in a conventional lens system.

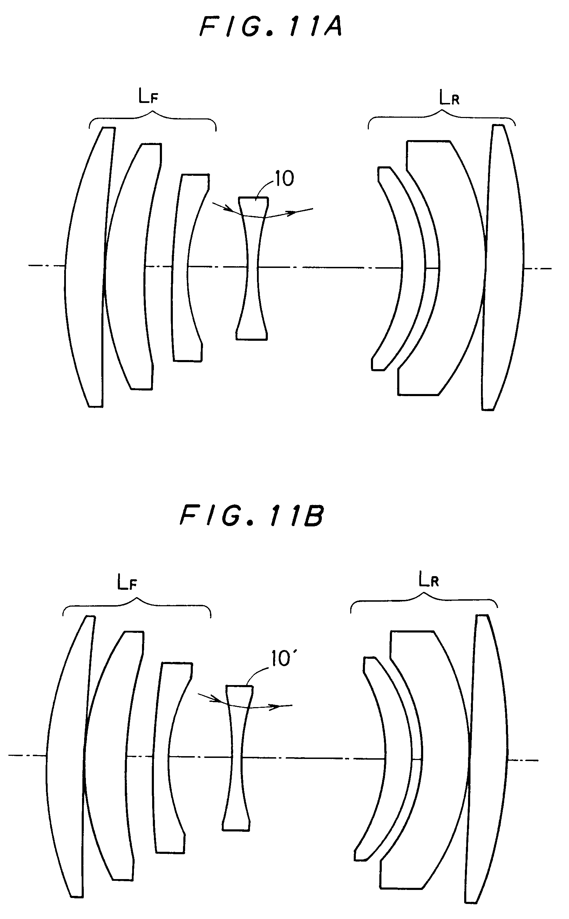

In the embodiments of the present invention, either optical elements 1 or 1', shaped into a parallel plane with a prescribed thickness of d, is employed depending on whether it is used in aligning or in exposing, as previously described. In stead of this, appropriate lenses, for example, two concave lenses may substitute for the above-mentioned interchangeable optical elements in order to achieve the object of the present invention: A concave lens 10 can be employed in aligning instead of the plane lens 1 to be corrected for chromatic aberration at the first and third wavelengths as shown in Fig. 11A, while a convex lens 10' can be employed in exposing instead of the plane glass 1' to be for correct chromatic aberration at the first and second wavelengths as shown in Fig. 11B.

In such a case, however, highly accurate replacement of the lenses 10 and 10' is required. Because the direction of light incident upon the lenses 10, 10' is largely different from the direction of light from in the lenses 10 and 10', whereby the positions of the lenses 10 and 10' have considerable influence on an image size in this lens structure. On the contrary to this, in the first and second embodiments of the present invention, the parallel plane shape of the optical element permits the direction of the incident light approximate to the direction of the outgoing light as shown in Figs. 3A and 3B. Consequently, the influence of the position of the optical element on an image size is negligible even if the optical elements 1 or 1' is not placed precisely on the optical axis. During aligning in particular, the influence on the image size is completely absent, since the plane glass 1' used in aligning enables the direction of the incident light identical to the direction of the outgoing light, i.e., the angle of the incident light $\theta_1$ is identical to that of the outgoing light $\theta_2$ (Fig. 3B). Accordingly, such a high accuracy is not demanded in replacing the optical elements 1 and 1' as in replacing the concave lenses 10 and 10'.

### E. Third and Fourth Embodiments

An apochromatic lens system suitable for photo-etching has been described in detail in the previous part of the specification. This lens system has no chromatic aberration at light with a long wavelength used for aligning and at light with two different short wavelengths used for exposing. Now, a correction for chromatic aberration at three different wavelength lights will be described. Such corrections can be achieved by combining glass materials properly.

In the following, the combinations of the glass materials will be described in detail by depicting embodiments.

E-1. Third Embodiment

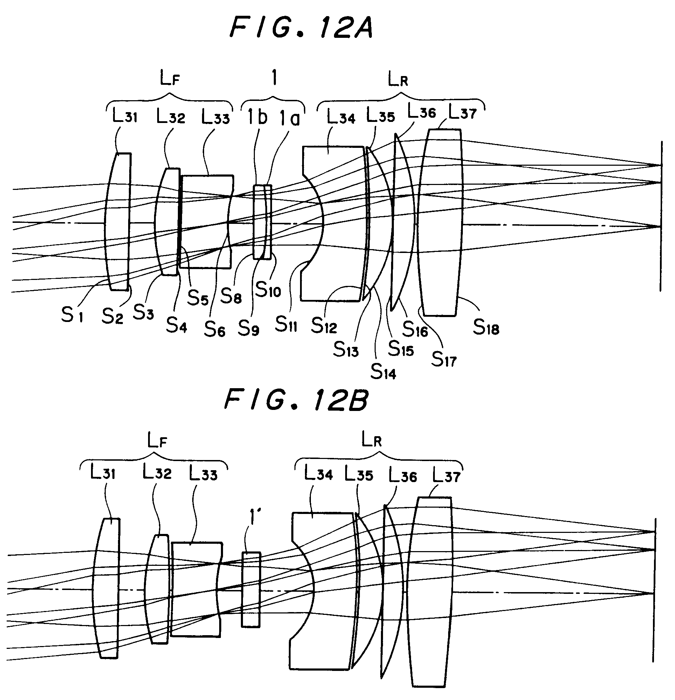

Figs. 12A and 12B are schematic diagrams of an apochromatic lens system according to the third embodiment of the present invention. Fig. 12A shows a first structure of the lens system and Fig. 12B shows a second structure of the same. The first lens system includes a front lens group $L_F$, a plane lens 1 and a rear lens group $L_R$ which are arranged serially from an object side (left-hand side of the figure), as can be seen in Fig. 12A. The front lens group $L_F$ includes a first to third lenses $L_{31}$ to $L_{33}$ serially arranged from the object side and spaced apart from each other. The values of the spacing between the three lenses will be described later. The plane lens 1 includes plano-concave and plano-convex lenses 1a and 1b having the same curvature. The curved surfaces of the plano-concave and the plano-convex lenses 1a and 1b are joined to each other to shape the plane lens 1 with parallel planes. The rear lens group $L_R$ includes a fourth to sixth lenses $L_{34}$ to $L_{36}$ serially arranged from the object side and spaced apart from each other. The values of spacing between the three lenses will be described later. Table 5A shows the lens data of the first lens system structured as above.

Table 5A

| j | radius of curvature $r_j$ | value of thickness or spacing $d_j$ | refractive index at d light | dispersion value $\nu_d$ |
|---|---|---|---|---|
| 1 | 18.91552 | 2.292062 | $n_1 = 1.74400$ | $\nu_1 = 44.8$ |
| 2 | -381.41801 | 2.233704 | | |
| 3 | 12.28960 | 2.223651 | $n_2 = 1.74400$ | $\nu_2 = 44.8$ |
| 4 | -98.01945 | 0.097696 | | |
| 5 | -65.59137 | 3.888889 | $n_3 = 1.75520$ | $\nu_3 = 27.5$ |
| 6 | 7.92120 | 0.283150 | | |
| 7 | ... | 2.040326 | | |
| 8 | ∞ | 0.972222 | $n_{1a} = 1.78472$ | $\nu_{1a} = 25.7$ |
| 9 | -84.49344 | 0.444444 | $n_{1b} = 1.78800$ | $\nu_{1b} = 47.4$ |
| 10 | ∞ | 4.409125 | | |
| 11 | -5.99319 | 3.712611 | $n_4 = 1.75520$ | $\nu_4 = 27.5$ |
| 12 | -86.28751 | 0.048162 | | |
| 13 | -71.18235 | 2.143318 | $n_5 = 1.69350$ | $\nu_5 = 53.2$ |
| 14 | -10.94487 | 0.027778 | | |
| 15 | -226.45067 | 1.809814 | $n_6 = 1.74400$ | $\nu_6 = 44.8$ |
| 16 | -17.83232 | 0.339249 | | |
| 17 | 41.06543 | 3.888889 | $n_7 = 1.74400$ | $\nu_7 = 44.8$ |
| 18 | -86.74715 | | | |

In the table, $r_j$ (i= 1, 2, ..., 6, 8, ..., 18) is the radius of curvature of a lens surface $S_j$. The symbol $r_9$ represents the radius of curvature of a joining surface $S_9$ of a plano-concave and a plano-convex lenses 1a and 1b. Symbols $d_1$, $d_3$, $d_5$, $d_8$, $d_9$, $d_{11}$, $d_{13}$, $d_{15}$ and $d_{17}$ are the thickness values of the first, the second, the third, the planoconcave, the plano-convex, the fourth to seventh lenses $L_{31}$, $L_{32}$, $L_{33}$, 1a, 1b, $L_{34}$ to $L_{37}$, respectively. Symbols $d_2$ and $d_4$ are the spacing values between the adjacent lenses of the three lenses $L_{31}$ to $L_{33}$. Symbol $d_6$ is the spacing value between the third lens $L_{33}$ and a stop (not shown in the figure), while $d_7$ is the spacing value between the stop and the plane lens 1. Symbols $d_{12}$, $d_{14}$ and $d_{16}$ are the spacing values between the adjacent lenses of the four lenses $L_{34}$ to $L_{37}$. Symbols $n_1$ to $n_7$ are indices of refraction of the first to seventh lenses $L_{31}$ to $L_{37}$ with respec to the d light (587.56 nm), respectively. Symbol $n_{1a}$ is the index of refraction of the planoconcave lens 1a while $n_{1b}$ is that of the plano-convex lens 1b. Symbols $\nu_1$ to $\nu_7$ denote the dispersion values of the first to seventh lenses $L_{31}$ to $L_{37}$, respectively. Symbols $\nu_{1a}$ and $\nu_{1b}$ denote the dispersion values of the plano-concave and plano-convex lenses 1a and 1b, respectively. The indices of refraction $n_{ea}$ and $n_{eb}$ of the plano-concave and the plano-convex lenses 1a and 1b with respect to the e line (546.07 nm) are given below for reference. These values are not provided in Table 5A. $n_{ea}$ = 1.79191, $n_{eb}$ = 1.79196

The focal length f, the total field angle 2θ, the distance IOD, between the object and the image, and the magnification M of this apochromatic lens system whose lens data are shown in Table 5A are set as follows:

f = 30.494,       2θ = 18.2°

IOD = 100.00,       M = 0.5

On the other hand, the second lens system shown in Fig. 12B is exactly the same in structure as the first lens system except that the plane glass 1' is used instead of the plane glass 1. The lens data of the lens system for exposing are shown in Table 5B.

Table 5B

| j | radius of curvature $r_j$ | value of thickness or spacing $d_j$ | refractive index at d light | dispersion value $\nu_d$ |
|---|---|---|---|---|
| 1 | 18.91552 | 2.292062 | $n_1$ =1.74400 | $\nu_1$ =44.8 |
| 2 | -381.41801 | 2.233704 | | |
| 3 | 12.28960 | 2.223651 | $n_2$ =1.74400 | $\nu_2$ =44.8 |
| 4 | -98.01945 | 0.097696 | | |
| 5 | -65.59137 | 3.888889 | $n_3$ =1.75520 | $\nu_3$ =27.5 |
| 6 | 7.92120 | 0.283150 | | |
| 7 | . . . | 2.040326 | | |
| 8 | ∞ | 1.416666 | | |
| 9 | . . . | . . . | n =1.78800 | ν =47.4 |
| 10 | ∞ | 4.409125 | | |
| 11 | -5.99319 | 3.712611 | $n_4$ =1.75520 | $\nu_4$ =27.5 |
| 12 | -86.28751 | 0.048162 | | |
| 13 | -71.18235 | 2.143318 | $n_5$ =1.69350 | $\nu_5$ =53.2 |
| 14 | -10.94487 | 0.027778 | | |
| 15 | -226.45067 | 1.809814 | $n_6$ =1.74400 | $\nu_6$ =44.8 |
| 16 | -17.83232 | 0.339249 | | |
| 17 | 41.06543 | 3.888889 | $n_7$ =1.74400 | $\nu_7$ =44.8 |
| 18 | -86.74715 | | | |

In the table, symbols $d_8$, n and ν denote the thickness, the refractive index with respect to the d light and the dispersion value of the plane glass 1', respectively. Other symbols are the same as those in Table 5A. The refractive index $n_e$ of the plane glass 1' at the $\underline{e}$ line (546.07 nm) is given for reference:

$n_e = 1.79196$

The focal length $\underline{f}$, the total field angle $2\theta$, the distance IOD between the object and the image and the magnification M of this apochromatic lens system whose lens data are shown in Table 5B are set as follows:

f = 30.494,  2θ = 18.2°

10D = 100.00,  M = 0.5

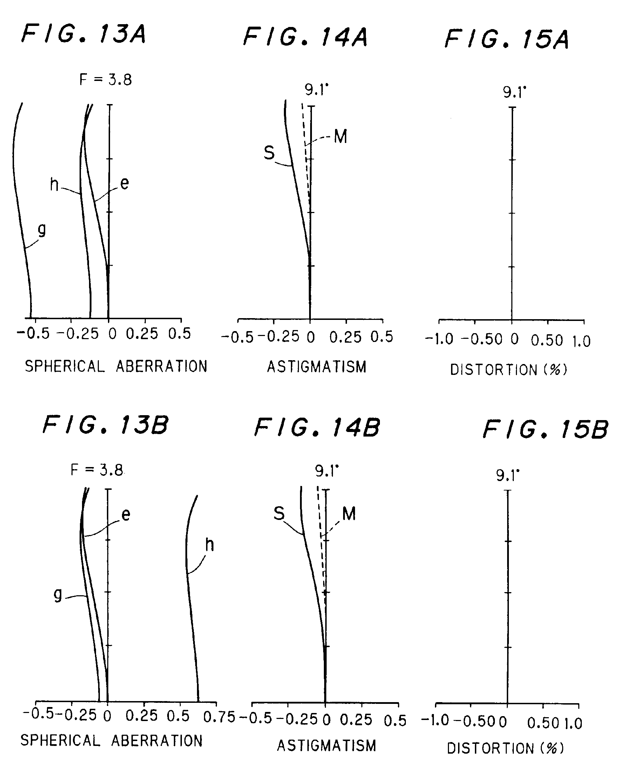

Figs. 13A and 13B show the spherical aberrations of the first and second lens systems, respectively. Figs. 14A and 14B show the astigmatisms of the first and second lens systems, respectively. Figs. 15A and 15B show the distortion aberrations of the first and second lens systems, respectively. In Figs. 14A and 14B, symbol S (solid lines) and symbol M (dotted lines) represent sagittal and meridional image surfaces with respect to the $\underline{e}$ line, respectively.

As can be understood from Figs. 13A and 13B, the first lens system is corrected for chromatic aberration at the $\underline{e}$ line and the $\underline{h}$ line, while the second lens system is corrected for chromatic aberration at the $\underline{e}$ line and the $\underline{g}$ line. Therefore, corrections of chromatic aberration at three wavelengths, (i.e., the $\underline{e}$, $\underline{g}$ and $\underline{h}$ line) can attained by replacing the optical element 1 and 1' as in the embodiments described above.

Additionally, as is obvious from Figs. 12A and 12B, the apochromatic lens system according to the third embodiment has a telecentric property on the image formation side. Thus, the present invention is available for a telecentric lens system as well.

In the third embodiment of the present invention, the plane glass 1' and the plano-concave lens 1a are made of the same glass material, while the plano-convex lens 1b is made of the glass material which is approximate to the mentioned glass material in refractive index but different from the same in dispersion value, similarly to the first and second embodiments. However, this combination of the glass materials is not limiting.

The third embodiment has been corrected for chromatic aberration at three wavelengths i.e., the $\underline{e}$, $\underline{g}$ and $\underline{h}$ line, where the $\underline{e}$ line is the first-wavelength light. Still further, if a combination of the glass materials is properly selected, it is possible that the lens system is corrected for chromatic aberration at the $\underline{e}$ line (first-wavelength light) and two arbitrary wavelengths. Table 6 shows examples of those combinations which enables such optional corrections.

Table 6

| glass material | $n_e$ | $\nu_e$ |
|---|---|---|
| SK9 | 1.61671 | 54.7 |
| KzFS4 | 1.61673 | 43.6 |
| SSK2 | 1.62508 | 52.9 |
| F11 | 1.62505 | 35.6 |
| LaSFO14 | 1.79196 | 47.1 |
| SF11 | 1.79191 | 25.5 |

### E-2. Fourth Embodiment

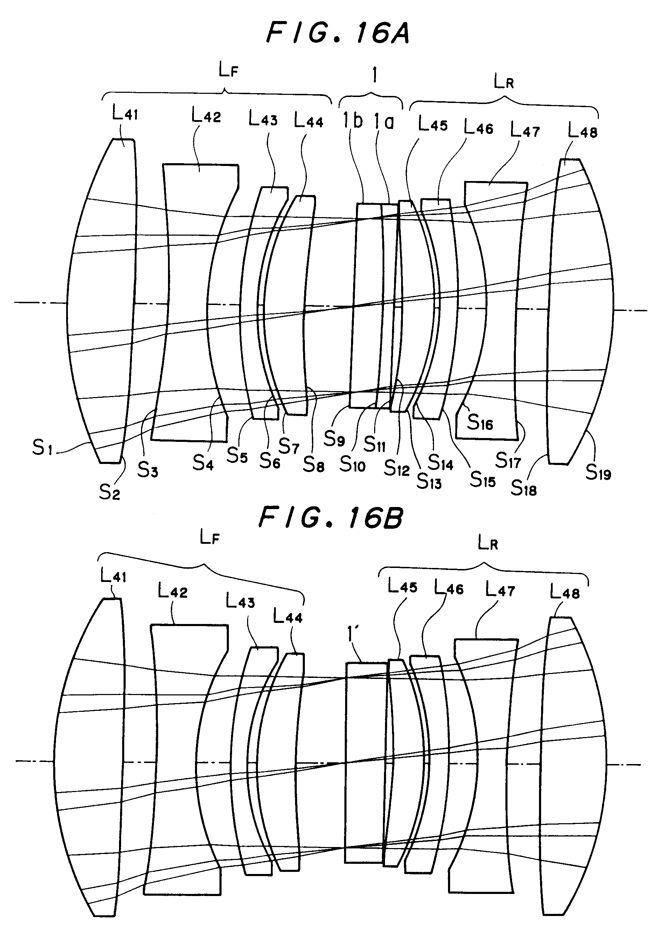

Figs. 16A and 16B are schematic diagrams of an apochromatic lens system according to the fourth embodiment of the present invention. Fig. 16A shows a first structure of the lens system and Fig. 16B shows a second structure of the same. The first lens system includes a front lens group $L_F$, a plane lens 1 and a rear lens group $L_R$ which are arranged serially from an object side (left-hand side of the figure), as can be seen in Fig. 16A. The front lens group $L_F$ includes a first to fourth lenses $L_{41}$ to $L_{44}$ serially arranged from the object side and spaced apart from each other. The values of the spacing between the four lenses $L_{41}$ to $L_{44}$ will be described later. The plane lens 1 includes plano-concave and plano-convex lenses 1a and 1b having the same

14

curvature. The curved surfaces of the plano-concave and plano-convex lenses 1a and 1b are joined to each other to thereby shape the plane lens 1 with parallel planes. The rear lens group $L_R$ includes a fifth to eighth lenses $L_{45}$ to $L_{48}$ serially arranged from the object side and spaced apart from each other. The values of spacing between the four lenses $L_{45}$ to $L_{48}$ will be described later. Table 7A shows the lens data of the first lens system structured as above.

Table 7A

| k | radius of curvature $r_k$ | value of thickness or spacing $d_k$ | refractive index at d light | dispersion value $\nu_d$ |
|---|---|---|---|---|
| 1 | 26.64523 | 5.233135 | $n_1 = 1.62041$ | $\nu_1 = 60.3$ |
| 2 | -163.92645 | 2.636136 | | |
| 3 | -79.94418 | 2.939450 | $n_2 = 1.52944$ | $\nu_2 = 51.7$ |
| 4 | 19.50754 | 2.780280 | | |
| 5 | 32.21472 | 1.466666 | $n_3 = 1.51633$ | $\nu_3 = 64.1$ |
| 6 | 18.41080 | 0.388155 | | |
| 7 | 18.17208 | 3.192347 | $n_4 = 1.49700$ | $\nu_4 = 81.6$ |
| 8 | 71.37663 | 3.779585 | | |
| 9 | $\infty$ | 2.000000 | $n_{1a} = 1.58921$ | $\nu_{1a} = 41.1$ |
| 10 | -446.01349 | 1.333333 | $n_{1b} = 1.58913$ | $\nu_{1b} = 61.2$ |
| 11 | $\infty$ | 0.399439 | | |
| 12 | -88.65313 | 2.713863 | $n_5 = 1.49700$ | $\nu_5 = 81.6$ |
| 13 | -19.13591 | 0.453135 | | |
| 14 | -19.56262 | 1.466666 | $n_6 = 1.51633$ | $\nu_6 = 64.1$ |
| 15 | -35.45453 | 2.305831 | | |
| 16 | -19.39756 | 2.273398 | $n_7 = 1.52944$ | $\nu_7 = 51.7$ |
| 17 | 74.96778 | 2.634602 | | |
| 18 | 156.28138 | 5.036366 | $n_8 = 1.62041$ | $\nu_8 = 60.3$ |
| 19 | -25.61406 | | | |

In the table, $r_k$ (k= 1, 2, ..., 19) is the radius of curvature of a lens surface $S_k$. For example, $r_1$ represents the radius of curvature of a convex surface $S_1$ of the first lens $L_{41}$, and $r_2$ represents the radius of curvature of a surface $S_2$ of the first lens $L_{41}$ which surface faces an image formation side. The symbol $r_{10}$ represents the

radius of curvature of the joining surface $S_{10}$ of the plano-concave and plano-convex lenses 1a and 1b. Symbols $d_1$, $d_3$, $d_5$, $d_7$, $d_9$, $d_{10}$, $d_{12}$, $d_{14}$, $d_{16}$ and $d_{18}$ are the thickness values of the first to fourth, plano-concave, plano-convex and fifth to eighth lenses $L_{41}$, $L_{42}$, $L_{43}$, $L_{44}$, 1a, 1b, $L_{45}$, $L4_6$, $L_{47}$ and $L_{48}$, respectively. Symbols $d_2$, $d_4$ and $d_6$ are the spacing values between the adjacent lenses of the four lenses $L_{41}$ to $L_{44}$. Symbol $d_8$ is the spacing value between the fourth lens $L_{44}$ and the plane lens 1, while $d_{11}$ is the spacing value between the fifth lens $L_{45}$ and the plane lens 1. Symbols $d_{13}$, $d_{15}$ and $d_{17}$ are the spacing values between the adjacent lenses of the four lenses $L_{45}$ to $L_{48}$. Symbols $n_1$ to $n_8$ are the indices of refraction of the first to eighth lenses $L_{41}$ to $L_{48}$ at the d light (587.56 nm), respectively. Symbol $n_{1a}$ is the index of refraction of the plano-concave lens 1a, while $n_{1b}$ is the index of the plano-convex lens 1b. Symbols $v_1$ to $v_8$ denote the dispersion values of the first to eighth lenses $L_{41}$ to $L_{48}$, respectively. The symbols $v_{1a}$ and $v_{1b}$ denote the dispersion values of the plano-concave and plano-convex lenses 1a and 1b, respectively.

The focal length $\underline{f}$, the total field angle $2\theta$, F number F and the magnification M of the apochromatic lens system whose lens data are shown in Table 7A are set as follows:

$f = 100.00$,     $2\theta = 19°$

$F = 5.6$,     $M = 1$

On the other hand, the second lens system shown in Fig. 16B is exactly the same in structure as the first lens system except that the plane glass 1' is used instead of the plane glass 1. The lens data of the second lens system are shown in Table 7B.

Table 7B

| k | radius of curvature $r_k$ | value of thickness or spacing $d_k$ | refractive index at d light | dispersion value $\nu_d$ |
|---|---|---|---|---|
| 1 | 26.64523 | 5.233135 | $n_1 = 1.62041$ | $\nu_1 = 60.3$ |
| 2 | -163.92645 | 2.636136 | | |
| 3 | -79.94418 | 2.939450 | $n_2 = 1.52944$ | $\nu_2 = 51.7$ |
| 4 | 19.50754 | 2.780280 | | |
| 5 | 32.21472 | 1.466666 | $n_3 = 1.51633$ | $\nu_3 = 64.1$ |
| 6 | 18.41080 | 0.388155 | | |
| 7 | 18.17208 | 3.192347 | $n_4 = 1.49700$ | $\nu_4 = 81.6$ |
| 8 | 71.37663 | 3.779585 | | |
| 9 | $\infty$ | 3.333333 | | |
| 10 | . . . | . . . | $n = 1.58913$ | $\nu = 61.2$ |
| 11 | $\infty$ | 0.399439 | | |
| 12 | -88.65313 | 2.713863 | $n_5 = 1.49700$ | $\nu_5 = 81.6$ |
| 13 | -19.13591 | 0.453135 | | |
| 14 | -19.56262 | 1.466666 | $n_6 = 1.51633$ | $\nu_6 = 64.1$ |
| 15 | -35.45453 | 2.305831 | | |
| 16 | -19.39756 | 2.273398 | $n_7 = 1.52944$ | $\nu_7 = 51.7$ |
| 17 | 74.96778 | 2.634602 | | |
| 18 | 156.28138 | 5.036366 | $n_8 = 1.62041$ | $\nu_8 = 60.3$ |
| 19 | -25.61406 | | | |

In the table, symbols $d_9$, n and $\nu$ in denote the thickness, the refractive index at the d light and the dispersion value of the plane glass 1', respectively. Other symbols are the same as those of Table 7A.

The focal length f, the total field angle $2\theta$, F number F and the magnification M of the apochromatic lens system whose lens data are shown in Table 7B are set as follows:

f = 100.00,     $2\theta = 19°$
F = 5.6,      M = 1

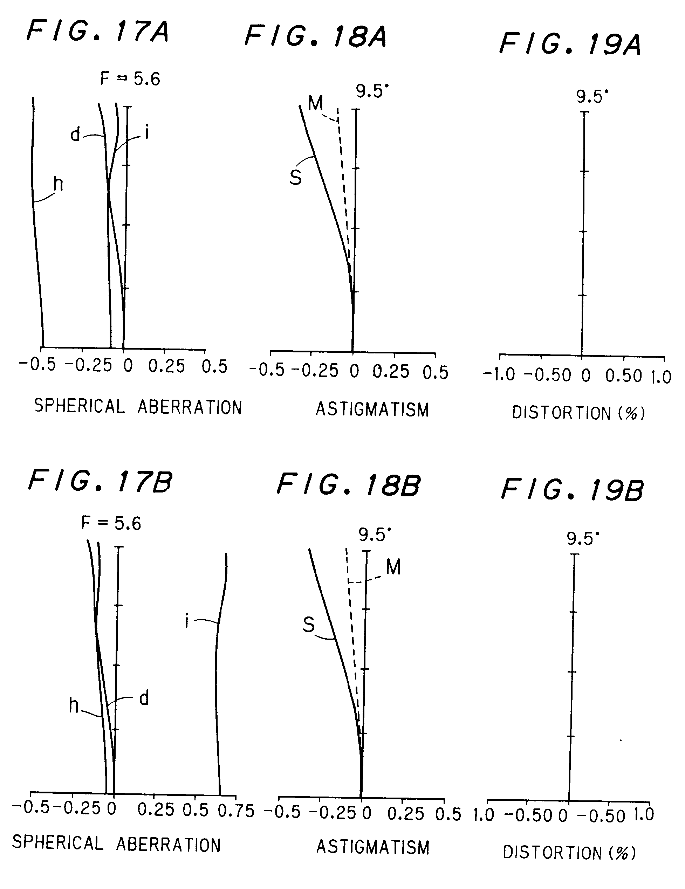

Figs. 17A and 17B show the spherical aberrations of the lens systems for aligning and for exposing, respectively. Figs. 18A and 18B show the astigmatisms of the lens systems for aligning and for exposing, respectively. Figs. 19A and 19B show the distortion aberrations of the lens systems for aligning and for exposing, respectively. In Figs. 17A and 17B, symbols d, h and i denote the spherical aberrations with respect to the d

17

light, the h line and i light (365.01 nm).

In Figs. 18A and 18B, symbol S (solid lines) and symbol M (dotted lines) represent sagittal and meridional image surfaces with respect to the d light, respectively.

As can be understood from Figs. 17A and 17B, the first lens system is corrected for chromatic aberration at the d and i light, while the second lens system is corrected for chromatic aberration at the d and h line. Therefore, corrections of chromatic aberration at three wavelengths, (i.e., the d, h and i line) can attained by replacing the optical elements 1 and 1' as in the embodiments set forth above.

Also in the fourth embodiment as in the embodiment above, the plane glass 1' and the plano-concave lens 1a are made of the same glass material, while the plano-convex lens 1b is made of the glass material which is approximate to the mentioned glass material in refractive index but different from the same in dispersion value. However, this combination of the glass materials is not limiting.

The third embodiment has been corrected for chromatic aberration at three wavelengths i.e., the d, h and i line, where the e line is the first-wavelength light. Still further, if a combination of the glass materials is properly selected, it is possible that the lens system is corrected for chromatic aberration at the e line (first-wavelength light) and two arbitrary wavelengths. Table 8 shows examples of those combinations which enables such optional corrections.

Table 8

| glass material | $n_d$ | $\nu_d$ |
|---|---|---|
| SK5 | 1.58913 | 61.2 |
| LF2 | 1.58921 | 41.1 |
| SK16 | 1.62041 | 60.3 |
| F9 | 1.62045 | 38.1 |
| LaK10 | 1.72000 | 50.2 |
| SFO1 | 1.72022 | 29.3 |

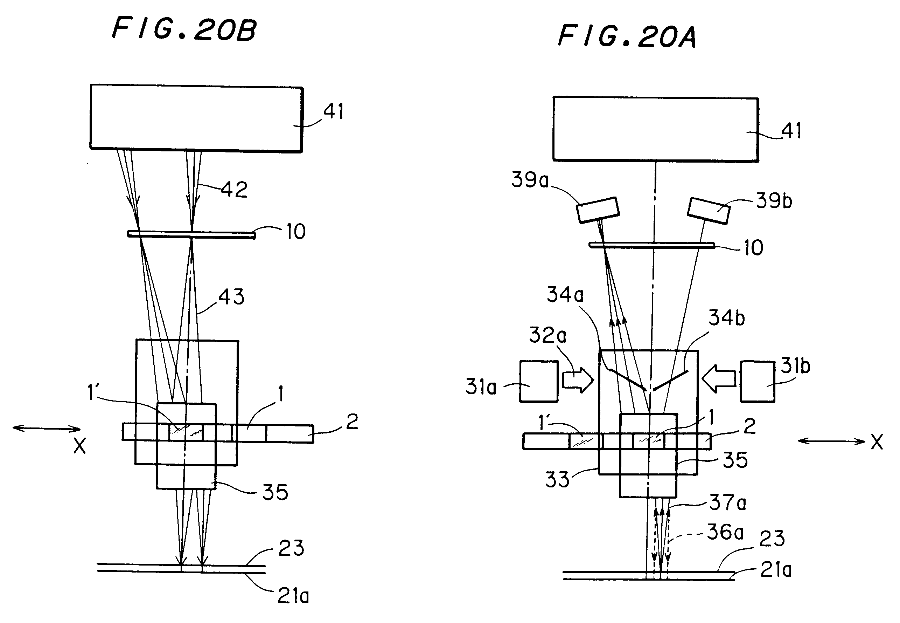

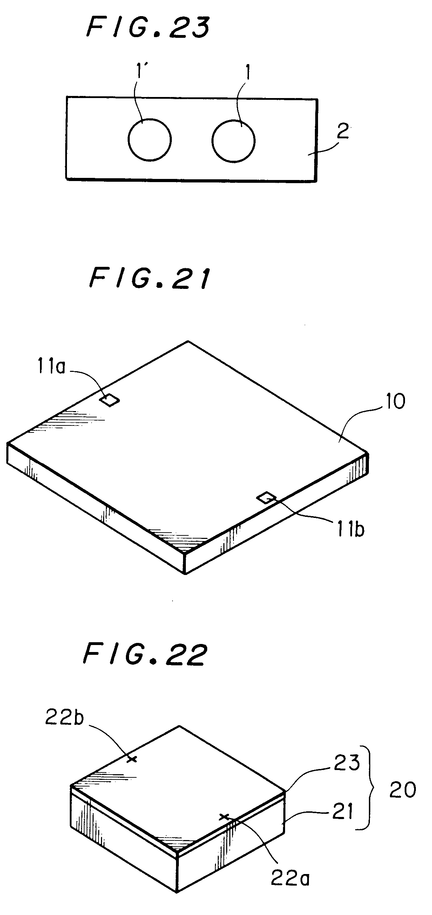

Figs. 20A and 20B illustrate structure of an exposing apparatus which employs the apochromatic lens system according to the first embodiment of the present invention. The exposing apparatus is used for transcribing a mask pattern of a photomask 10 shown in Fig. 21 on a semiconductor device 20 of Fig. 22. As can be seen in Fig. 21, marks 11a and 11b for aligning mask patterns are provided in prescribed positions on a surface of the photomask 10. In Fig. 22, cross marks 22a and 22b are provided on a substrate 21 of the semiconductor device 20 correspondingly to the positions of the marks 11a and 11b. The semiconductor device 20 includes a photoresist layer 22.

As shown in Fig. 20A, the exposing apparatus includes an illumination unit 31a for emitting the e line. Light radiations 32a of the e line from the illumination unit 31a are reflected at a half mirror 34a provided in a housing 33, and lead to a projection lens system 35. The projection lens system 35 is identical in structure to the afore-described apochromatic lens system according to the first embodiment. A holder 2 holds a plane lens 1 and a plane glass 1' as shown in Fig. 23. Thus, either the plane lens 1 or the plane glass 1' is disposed on the optical axis of the projection lens system 35 by positioning the holder 2.

Light radiations 36a of the e line through the projection lens system 35 is incident upon vicinity of the alignment mark 22a on a surface 21a of the substrate 21. Thus, the vicinity of the alignment mark 22a is illuminated. Light radiations 37a reflected from the substrate surface 21a are focused at the mark 11a placed on the photomask 10 through the projection lens system 35 and the half mirror 34a. Then, overlapped images of the mark 11a and the alignment mark 22a are received in a camera unit 39a.

The exposing apparatus also includes an illumination unit 31b for emitting the e line. The exposing apparatus is designed as above so as to allow overlapped images of the mark 11b and the alignment mark 22b to be received in a camera unit 39b.

As shown in Fig. 20B, an illumination optical system 41 is provided above the photomask 10 to irradiate with the g line and the h line. The illumination optical system 41 emits light radiations 42 of the g line and the h line, then light radiations 43 of the g line and the h line transmitted through the photomask 10 irradiate a photoresist layer 23 through the projection lens system 35. As a result, portion of the photoresist layer 23 which corresponds only to a pattern (not shown) formed on the photomask 10 photochemically changes.

The illumination units 31a and 31b, the half mirrors 34a and 34b and the camera units 39a and 39b can be moved between the respective positions shown in Fig. 20A and positions where they do not intercept the light radiation from the illumination optical system 41. The holder 2 is also movable along an X direction. In aligning, accordingly, the illumination units 31a and 31b and the other units can be placed in prescribed positions in order to obtain overlapped images of marks of the photomask 10 and alignment marks of the substrate 21 (Fig. 20A). On the other hand in exposing, the illumination units 31a and 31b and the other units are set back to prescribed withdraw positions while the plane glass 1' is placed on the optical axis of the projection lens system 35, in order to allow the g line and the h line to irradiate the photoresist layer 23.

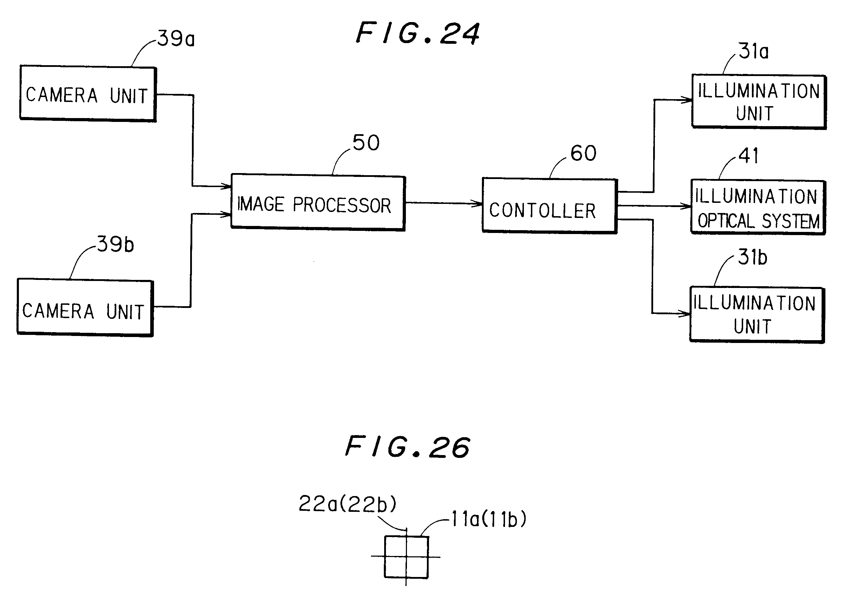

Fig. 24 is a block diagram showing electrical structures of the exposing apparatus. As in the figure, image data obtained in the camera units 39a and 39b are supplied to an image processor 50, and are processed therein according to predetermined procedures. Processed image data are then provided to a controller 60. The controller 60, which is connected with respective units of the exposing apparatus e.g., the illumination units 39a and 39b and the illumination optical system 41, carries out aligning and exposing as described later while controlling the whole apparatus.

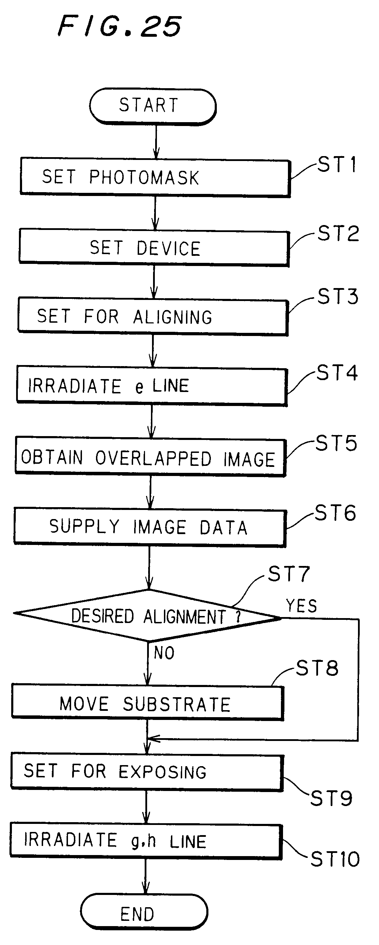

Fig. 25 is a flow chart showing operations of the exposing apparatus constructed as above. The photomask 10 14 is first set in a prescribed position (Step ST 1), then the semiconductor device 20 to be exposed is next set in an exposing position (Step ST2). According to an instruction given from the controller 60 in response this, the illumination units 31a and 31b, the half mirrors 34a and 34b and the camera units 39a and 39b are moved to the prescribed aligning positions shown in Fig. 20A (Step ST3). At the same time, the holder 2 moves so as to place the plane lens 1 on the optical axis of the projection lens system 35. Thereafter, the illumination units 39a and 39b emit the e line for illuminating the surface to be exposed, i.e., the surface 21a (Step ST4). Light radiations reflected at the exposing surface are focused at the marks 11a and 11b on the photomask 10. Then, overlapped images of the mark 11a with the alignment mark 22a and the mark 11b with the alignment mark 22b are obtained with the camera units 39a and 39b (Step ST5). Next, in Step ST6, the data of the overlapped images are supplied to the image processor 50, and are processed therein according to predetermined procedures. Then in Step ST7, it is judged whether or not the marks 11a and 11b and the alignment marks 22a and 22b are properly aligned, respectively. Step ST9 is then carried out if it is judged that the mark 11a and the alignment mark 22a are properly aligned to each other as well as the mark 11b and the alignment mark 22b are. On the contrary, if it is judged that the desired alignment of the marks and the alignment marks is not obtained, Step ST8 is carried out prior to Step ST9. In other words, the substrate 21 is moved until the marks 11a and 11b and the alignment marks 22a and 22b are properly aligned, respectively.

The illumination units 31a and 31b, the half mirrors 34a and 34b and the camera units 39a and 39b are moved to the withdraw positions in response to an instruction from the controller 60 in Step ST9. While at the same time, the holder 2 is moved so that the plane glass 1' is placed on the optical axis of the projection lens system 35. Thereafter in Step ST10, the illumination optical system 41 emits the e-line and h-line light, thus eventually irradiating the surface to be exposed, i.e., the surface 21a by the g line and the h line. Thus, the pattern of the photomask 10 is transcribed onto the photoresist 23 for a short time.

Although the present invention has been described and illustrated in detail, it is clearly understood that the same is by way of illustration and example only and is not to be taken by way of limitation. The scope of the present invention is limited only by the terms of the appended claims.

## Claims

1. An apochromatic lens system comprising a lens system ($L_F$, $L_R$) to be corrected for chromatic aberration, characterised by: a plane glass (1') for cooperating with said lens system ($L_F$, $L_R$) to correct for chromatic aberration at first and second wavelengths (g and h) when said plane glass (1') is disposed on the optical axis of said lens system ($L_F$, $L_R$); and a plane lens (1) formed by a plano-convex lens (1b) and a plano-concave lens (1a), the concave surface of said plano-concave lens (1a) facing the convex surface of said plano-convex lens (1b) whereby said plane lens (1) is identical to said plane glass (1') in thickness, said plane lens (1) being interchangeable with said plane glass (1'), said plane lens cooperating with said lens system ($L_F$, $L_R$) to correct for chromatic aberration at one of said first and second wavelengths (g and h) and a third wavelength (e) when said plane lens (1) is disposed on the optical axis of said lens system (L_F, L_R). 

2. An apochromatic lens system according to claim 1, wherein one of said plano-convex and plano-concave lenses (1b or 1a) is made of a first glass material, and the other (1a or 1b) is made of a second glass material having approximately the same refractive index as said first glass material but having a dispersion value different from said first glass material.

3. An apochromatic lens system according to claim 2, wherein said first glass material is the same as the glass material of said plane glass (1').

4. An apochromatic lens system according to any one of claims 1 to 3, wherein said convex and concave surfaces of said plano-convex and plano-concave lens (1b and 1a) have the same radius of curvature.

5. An apochromatic lens system according to claim 4, wherein said convex and concave surfaces are joined to each other.

6. An apochromatic lens system according to any preceding claim, wherein said lens system (L_F, L_R) comprises first (L_F) and second (L_R) lens groups.

7. An apochromatic lens system according to claim 6, wherein said plane glass (1') and said plane lens (1) are interchangeably disposed between said first and second lens groups (L_F and L_R).

8. An apochromatic lens system according to any preceding claim, wherein said plane glass (1') is selectively movable along the optical axis of said lens system (L_F, L_R).

9. An apochromatic lens system according to any preceding claim, wherein said plane lens (1) is selectively movable along the optical axis of said lens system (L_F, L_R).

## Patentansprüche

1. Ein apochromatisches Linsensystem mit einem bezüglich der chromatischen Aberration zu korrigierenden Linsensystem (L_F, L_R),
gekennzeichnet durch
ein ebenes Glas (1') zum Zusammenwirken mit dem bezüglich der chromatischen Aberration bei ersten und zweiten Wellenlängen (g und h) zu korrigierenden Linsensystem (L_F, L_R), wenn das ebene Glas (1') auf der optischen Achse des Linsensystems (L_F, L_R) angeordnet ist; und eine ebene Linse (1), die durch eine plan-konvexe Linse (1b) und eine plan-konkave Linse (1a) gebildet ist, wobei die konkave Oberfläche der plan-konkaven Linse (1a) zu der konvexen Oberfläche der plan-konvexen Linse (1b) weist, wodurch die ebene Linse (1) in ihrer Dicke derjenigen des ebenen Glases (1') gleich ist und wobei die ebene Linse (1) mit dem ebenen Glas (1') austauschbar ist und die ebene Linse mit dem Linsensystem (L_F, L_R) für die chromatische Aberration bei einer der ersten und der zweiten Wellenlängen (g und h) und der dritten Wellenlänge (e), zusammenwirkt, wenn die ebene Linse (1) auf der optischen Achse des Linsensystems (L_F, L_R) angeordnet ist.

2. Ein apochromatisches Linsensystem nach Anspruch 1, wobei die plan-konvexe Linse oder die plan-konkave Linse (1b und 1a) aus einem ersten Glasmaterial gefertigt ist und die andere (1a oder 1b) aus einem zweiten Glasmaterial gefertigt ist, das annähernd denselben Refraktionsindex hat wie das erste Glasmaterial, jedoch einen Dispersionswert hat, der von dem des ersten Glasmaterials abweicht.

3. Ein apochromatisches Linsensystem nach Anspruch 2, wobei das erste Glasmaterial dasselbe wie das Glasmaterial des ebenen Glases (1') ist.

4. Ein apochromatisches Linsensystem nach einem der Ansprüche 1 bis 3, wobei die konvexen und die konkaven Flächen der plan-konvexen und der plan-konkaven Linse (1b und 1a) denselben Krümmungsradius haben.

5. Ein apochromatisches Linsensystem nach Anspruch 4, wobei die konvexen und die konkaven Flächen miteinander verbunden sind.

**6.** Ein apochromatisches Linsensystem nach einem der vorangehenden Ansprüche, wobei das Linsensystem ($L_F$, $L_R$) erste ($L_F$) und zweite ($L_R$) Linsengruppen hat.

**7.** Ein apochromatisches Linsensystem nach Anspruch 6, wobei das ebene Glas (1′) und die ebene Linse (1) austauschbar zwischen der ersten und der zweiten Linsengruppe ($L_F$ und $L_R$) angeordnet ist.

**8.** Ein apochromatisches Linsensystem nach einem der vorangehenden Ansprüche, wobei das ebene Glas (1′) einstellbar entlang der optischen Achse des Linsensystems ($L_F$, $L_R$) beweglich ist.

**9.** Ein apochromatisches Linsensystem nach einem der vorangehenden Ansprüche, wobei die ebene Linse (1) einstellbar entlang der optischen Achse des Linsensystems ($L_F$, $L_R$) beweglich ist.


**Revendications**

**1.** Système d'objectif apochromatique comprenant un système d'objectif ($L_F$, $L_R$) à corriger pour l'aberration chromatique, caractérisé par : un verre plan (1′) pour coopérer avec ledit système d'objectif ($L_F$, $L_R$) à corriger pour l'aberration chromatique à des première et seconde longueurs d'onde (g et h) lorsque ledit verre plan (1′) est disposé sur l'axe optique dudit système d'objectif ($L_F$, $L_R$) ; et un objectif plan (1) formé par une lentille plan-convexe (1b) et par une lentille plan-concave (1a), la surface concave de ladite lentille plan-concave (1a) faisant face à la surface convexe de ladite lentille plan-convexe (1b), de sorte que ledit objectif plan (1) est identique en épaisseur audit verre plan (1′), ledit objectif plan (1) étant interchangeable avec ledit verre plan (1′), ledit objectif plan coopérant avec ledit système d'objectif ($L_F$, $L_R$) pour corriger l'aberration chromatique à l'une desdites première et deuxième longueurs d'onde (g et h) et à une troisième longueur d'onde (e) lorsque ledit objectif plan (1) est disposé sur l'axe optique dudit système d'objectif ($L_F$, $L_R$).

**2.** Système d'objectif apochromatique selon la revendication 1, dans lequel l'une desdites lentilles plan-convexe et plan-concave (1b ou 1a) est faite d'une première matière de verre, et dans lequel l'autre lentille (1a ou 1b) est faite d'une seconde matière de verre ayant à peu près le même indice de réfraction que ladite première matière de verre, mais ayant une valeur de dispersion différente de celle de ladite première matière de verre.

**3.** Système d'objectif apochromatique selon la revendication 2, dans lequel ledit premier matériau de verre est le même que le matériau de verre dudit verre plan (1′).

**4.** Système d'objectif apochromatique selon l'une quelconque des revendications 1 à 3, dans lequel lesdites surfaces convexe et concave desdites lentilles plan-convexe et plan-concave (1b et 1a) ont le même rayon de courbure.

**5.** Système d'objectif apochromatique selon la revendication 4, dans lequel lesdites surfaces convexe et concave sont jointives.

**6.** Système d'objectif apochromatique selon l'une quelconque des revendications précédentes, dans lequel ledit système d'objectif ($L_F$, $L_R$) comprend un premier groupe de lentilles ($L_F$) et un second groupe de lentilles ($L_R$).

**7.** Système d'objectif apochromatique selon la revendication 6, dans lequel ledit verre plan (1′) et ledit objectif plan (1) sont disposés, de manière interchangeable, entre lesdits premier et second groupes de lentilles ($L_F$ et $L_R$).

**8.** Système d'objectif apochromatique selon l'une quelconque des revendications précédentes, dans lequel ledit verre plan (1′) est mobile, de façon sélective, le long de l'axe optique dudit système d'objectif ($L_F$, $L_R$).

**9.** Système d'objectif apochromatique selon l'une quelconque des revendications précédentes, dans lequel ledit objectif plan (1) est mobile, de façon sélective, le long de l'axe optique dudit système d'objectif ($L_F$, $L_R$).

## FIG. 1A

## FIG. 1B

# F I G. 2A

SPHERICAL ABERRATION

# F I G. 2B

SPHERICAL ABERRATION

# F I G. 3A

# F I G. 3B

## FIG.4A

F = 4

e

g

h

-0.5 -0.25 0 0.25 0.5

SPHERICAL ABERRATION

## FIG.5A

M

11°

S

-0.5 -0.25 0 0.250.5

ASTIGMATISM

## FIG.6A

11°

-1.0 -0.50 0 0.50 1.0

DISTORTION (%)

## FIG.4B

F = 4

g

h

e

-0.5 -0.25 0 0.25 0.5 0.75

SPHERICAL ABERRATION

## FIG.5B

11°

M

S

-0.5 -0.25 0 0.25 0.5

ASTIGMATISM

## FIG.6B

11°

-1.0 -0.50 0 0.50 1.0

DISTORTION (%)

# F I G. 7A

# F I G. 7B

EP 0 416 651 B1

FIG.8A

F = 4

e   h

g

-0.5 -0.25 0 0.25 0.5

SPHERICAL ABERRATION

FIG.9A

11°

S   M

-0.5 -0.25 0  0.25 0.5

ASTIGMATISM

FIG.10A

11°

-1.0 -0.50 0  0.50  1.0

DISTORTION (%)

FIG.8B

F = 4

g   h   e

-0.5 -0.25 0 0.25 0.50 0.75

SPHERICAL ABERRATION

FIG.9B

11°

S   M

-0.5 -0.25 0  0.25  0.5

ASTIGMATISM

FIG.10B

11°

-1.0 -0.50 0  0.50 1.0

DISTORTION (%)

# FIG. 11A

# FIG. 11B

## F I G. 12A

## F I G. 12B

## FIG. 13A

F = 3.8

h

e

g

-0.5 -0.25 0 0.25 0.5

SPHERICAL ABERRATION

## FIG. 14A

9.1°

S

M

-0.5 -0.25 0 0.25 0.5

ASTIGMATISM

## FIG. 15A

9.1°

-1.0 -0.50 0 0.50 1.0

DISTORTION (%)

## FIG. 13B

F = 3.8

e

h

g

-0.5 -0.25 0 0.25 0.5 0.75

SPHERICAL ABERRATION

## FIG. 14B

9.1°

S

M

-0.5 -0.25 0 0.25 0.5

ASTIGMATISM

## FIG. 15B

9.1°

-1.0 -0.50 0 0.50 1.0

DISTORTION (%)

## FIG. 16A

## FIG. 16B

## FIG. 17A

F = 5.6

d i

h

-0.5 -0.25 0 0.25 0.5

SPHERICAL ABERRATION

## FIG. 18A

9.5°

M

S

-0.5 -0.25 0 0.25 0.5

ASTIGMATISM

## FIG. 19A

9.5°

-1.0 -0.50 0 0.50 1.0

DISTORTION (%)

## FIG. 17B

F = 5.6

i

h d

-0.5 -0.25 0 0.25 0.5 0.75

SPHERICAL ABERRATION

## FIG. 18B

9.5°

M

S

-0.5 -0.25 0 0.25 0.5

ASTIGMATISM

## FIG. 19B

9.5°

1.0 -0.50 0 -0.50 1.0

DISTORTION (%)

*FIG.20B*

*FIG.20A*

EP 0 416 651 B1

# FIG.23

# FIG.21

# FIG.22

# FIG.24

CAMERA UNIT ~39a

CAMERA UNIT ~39b

IMAGE PROCESSOR ~50

CONTOLLER ~60

ILLUMINATION UNIT ~31a

ILLUMINATION OPTICAL SYSTEM ~41

ILLUMINATION UNIT ~31b

# FIG.26

22a(22b) ——11a(11b)

EP 0 416 651 B1

# F I G. 25

```
              ┌─────────────┐
              │    START    │
              └──────┬──────┘
                     │
         ┌───────────▼───────────┐
         │    SET PHOTOMASK      │────ST1
         └───────────┬───────────┘
                     │
         ┌───────────▼───────────┐
         │      SET DEVICE       │────ST2
         └───────────┬───────────┘
                     │
         ┌───────────▼───────────┐
         │    SET FOR ALIGNING   │────ST3
         └───────────┬───────────┘
                     │
         ┌───────────▼───────────┐
         │    IRRADIATE e LINE   │────ST4
         └───────────┬───────────┘
                     │
         ┌───────────▼───────────┐
         │ OBTAIN OVERLAPPED IMAGE│────ST5
         └───────────┬───────────┘
                     │
         ┌───────────▼───────────┐
         │   SUPPLY IMAGE DATA   │────ST6
         └───────────┬───────────┘
                     │                    ST7
                     ▼
              ◇ DESIRED ALIGNMENT ? ◇────YES──┐
                     │                        │
                    NO                        │
                     │              ST8       │
         ┌───────────▼───────────┐            │
         │    MOVE SUBSTRATE     │            │
         └───────────┬───────────┘            │
                     │◄───────────────────────┘
         ┌───────────▼───────────┐
         │    SET FOR EXPOSING   │
         └───────────┬───────────┘────ST9
                     │
         ┌───────────▼───────────┐
         │   IRRADIATE g,h LINE  │
         └───────────┬───────────┘────ST10
                     │
              ┌──────▼──────┐
              │     END     │
              └─────────────┘
```